# EUROPÄISCHE PATENTSCHRIFT

(11) **EP 2 273 182 B1**
(45) Veröffentlichungstag und Bekanntmachung des Hinweises auf die Patenterteilung: **19.12.2018**
(21) Anmeldenummer: 10168290.4
(22) Anmeldetag: 02.07.2010
(51) Int. Cl.: H05K 1/02, H05K 1/05, F21K 9/00, F21V 29/76

(54) **Dreidimensionales LED-Trägerelement mit thermischer Leitfähigkeit**
Three-dimensional LED holder element with thermal conductivity
Elément de support à DEL tridimensionnel doté d'une conductivité thermique

(30) Priorität: 07.07.2009 DE 102009032081
(43) Veröffentlichungstag der Anmeldung: 12.01.2011
(73) Patentinhaber: Siteco Beleuchtungstechnik GmbH, 83301 Traunreut (DE)
(72) Erfinder: Metzeroth, Stefan, 83250, Marquartstein (DE); Härtl, Michael, 83278, Traunstein (DE); Meyer, Clemens, 83278, Traunstein (DE); Prodell, Peter, 83308, Trostberg (DE)
(74) Vertreter: Schmidt, Steffen

(56) Entgegenhaltungen:
- WO-A1-93/15594
- DE-A1-102006 033 873
- DE-A1-102007 041 817
- US-A- 3 922 386
- US-A- 6 158 341
- US-A1- 2001 022 564
- US-A1- 2004 091 818
- US-A1- 2007 217 221
- US-A1- 2007 291 482
- US-A1- 2008 035 943
- US-A1- 2008 257 585
- Clyde F. Coombs: "Vapor-Phase Reflow Soldering" In: "Printed Circuits Handbook (Sixth Edition)", 29 August 2007 (2007-08-29), McGraw-Hill Professional, XP055071693, ISBN: 0071467343 pages 47.42-47.43, * the whole document *

## Beschreibung

Die vorliegende Erfindung betrifft ein LED-Trägerelement einer Leuchte, welche als Leuchtmittel LEDs aufweist.

Die Entwicklungen auf dem technischen Gebiet der LEDs (lichtemittierender Dioden) hat es ermöglicht, derart lichtstarke LEDs zu erzeugen, so dass Leuchten ausschließlich mit LEDs als Leuchtmittel sowohl aus Außenleuchten als auch als Innenleuchten hergestellt werden können. Die LEDs sind dabei in der Regel auf einem Trägerelement angeordnet.

Eine besondere Schwierigkeit bei der Konstruktion derartiger Leuchten besteht darin, dass die im Betrieb der LEDs erzeugte Wärme abgeführt werden muss. Dazu sind Trägerelemente aus entsprechenden wärmeleitfähigen Materialien erforderlich. Diese wiederum sind jedoch häufig elektrisch leitfähig, so dass im Stand der Technik bislang die LEDs auf separaten Platinen aufgebracht wurden, die ihrerseits auf dem Trägerelement befestigt werden. Ein Nachteil dieser Konstruktion ist jedoch, dass die Platine den Wärmeübergang zwischen den LEDs und dem Trägerelement verringert.

Eine weitere Anforderung an die Trägerelemente besteht darin, dass sie in einer Leuchte räumlich so angebracht werden müssen, dass die Abstrahlrichtung der LEDs zur Erzeugung einer gewünschten Lichtverteilung in die entsprechenden Raumwinkelbereiche zeigen.

DE 10 2006 033 873 A1 offenbart eine strahlungsemittierende Einrichtung mit mehreren strahlungsemittierenden Bauelementen und eine Beleuchtungseinrichtung. Auf einem Trägerkörper können in unterschiedlichen Oberflächenbereichen Beleuchtungseinrichtungen, insbesondere LEDs, angebracht werden, wobei die Beleuchtungseinrichtungen in unterschiedliche Raumrichtungen zeigen. Auf der Oberfläche des Trägerkörpers ist eine elektrisch isolierende Matrix, z. B. eine Oxidschicht, und elektrische Zuleitungen aufgebracht. Die elektrisch leitende Schicht kann durch Aufdampf- oder Aufschleudertechniken aufgebracht werden. Ferner sind, um eine Delamination der elektrisch isolierenden Matrix im Bereich von Ecken und Kanten des Trägerkörpers zu verhindern, entsprechende Biegeradien vorgeschlagen.

DE 10 2007 041 817 A1 offenbart ein Leuchtmodul und dessen Herstellung. Auf einem Trägerkörper sind in mindestens zwei Ebenen und/oder Orientierungen Leuchteneinheiten aufgebracht, die mit Leiterbahnen verbunden und/oder kontaktiert sind. Der Trägerkörper wird mittels eines Laserbestrahlung- und oder mittels eines Plasmas aktiviert. Die Leiterbahnen werden galvanisch aufgebracht.

US 2007/0291482 A1 offenbart eine Beleuchtungsvorrichtung mit einem dreidimensionalen Substrat, welches die Form einer klassischen Glühlampe annimmt. Auf dem Substrat sind LEDs angeordnet und elektrisch kontaktiert.

US 6,158,341 offenbart ein Verfahren zum Übertragen eines Bildes auf einer Oberfläche eines Gehäuses eines Mobiltelefons. Das Bild wird mittels eines Tampons aufgedruckt.

US 2008/0257585 A1 offenbart ein elektrisches Leistungssubstrat, welches durch eine plasmaelektrolytische Oxidation behandelt worden ist. Eine metallische Resonanzschicht wird durch Siebdruck aufgebracht und im nachfolgenden Schritt ist zur selektiven Vergrößerung der Dicke und der Fläche ein galvanisches Verfahren vorgesehen.

US 2004/091818 A1 offenbart ein Herstellungsverfahren für eine dreidimensionale Schaltung auf einem geformten Polymersubstrat. Leiterbahnen werden durch eine katalytische Beschichtung und eine anschließende Galvanisierung erzeugt, wobei die katalytische Beschichtung auch durch Tampondruck aufgebracht werden kann.

Es ist die Aufgabe der vorliegenden Erfindung, ein LED-Trägerelement zu bilden, welches eine gewünschte Ausrichtung der LEDs ermöglicht, für die Kühlung der LEDs sorgt und dennoch einfach herzustellen ist.

Die Aufgabe wird gelöst durch ein LED-Trägerelement nach Anspruch 1 und ein Verfahren nach Anspruch 8.

Von besonderem Vorteil ist dabei, dass die Trägerfläche nicht eben ist, sondern durch die Krümmung oder die Abkantungen in unterschiedliche räumliche Richtungen weist. Dadurch können LEDs auf der Oberfläche eines Trägerelements angebracht werden, die zur Erzeugung einer gewünschten Lichtverteilung der Leuchte in unterschiedliche Raumrichtungen ausgerichtet sind. Andererseits wird diese gekrümmte oder mit Abkantungen versehene Fläche gleichzeitig als Trägerfläche für Leiterbahnen genutzt, die für die elektrische Versorgung der LEDs dienen. Bei herkömmlichen Leuchten werden die LEDs mit Kabeln und Steckverbindungen auf einer ebenen Fläche elektrisch versorgt oder auf separaten Platinen angebracht, was in der Herstellung zu einem besonders hohen Aufwand führt. Durch die Verwendung von Leiterbahnen auf der gekrümmten oder abgewinkelten Trägerfläche wird dieser Nachteil vermieden.

Gemäß einer bevorzugten Ausführungsform weist das Trägerelement ein Material mit einer Wärmeleitfähigkeit von wenigstens 15 W/Km auf, wobei ein Material mit wenigstens 100 W/Km bevorzugt ist. Bei dieser Wärmeleitfähigkeit ist es möglich, die von den LEDs erzeugte Wärme abzuführen. Die Kühlung der LEDs ist dadurch besonders effizient, weil die LEDs aufgrund der Montage auf den Leiterbahnen in engem thermischen Kontakt mit dem LED-Trägerelement stehen.

Erfindungsgemäß ist der Körper des Trägerelements aus einem metallischen Material gebildet, insbesondere aus Aluminium oder einer Aluminium-Legierung.

Erfindungsgemäß ist zwischen der Trägerfläche und den Leiterbahnen eine elektrische Isolierschicht vorgesehen, insbesondere eine Oxidschicht oder eine keramische Schicht. Die Isolierschicht sorgt bei einem metallischen Körper des Trägerelements dafür, dass kein Kurzschluss zwischen den Leiterbahnen und dem Körper entsteht. Besonders wichtig ist dabei, dass sich die Isolierschicht über die Krümmung oder die Abkantungen der Trägerfläche hin erstrecken, so dass auf der gesamten Trägerfläche auf eine herkömmliche Verkabelung, wie z.B. Brücken- oder Steckverbindungen, verzichtet werden kann. Die Isolierschicht ist vorzugsweise mit einer konstanten Dicke über die Krümmung oder die Abkantungen hinweg aufgebracht.
Als elektrische Isolierschicht kann gemäß einer Ausführungsform der Erfindung eine keramische Schicht angewandt werden. Beispielsweise kann eine Metalloxidschicht mittels plasmaelektronischer Oxidation (PEO) aufgebracht werden. Bevorzugt ist die Isolierschicht zwischen 5 µm und 200 µm dick. Alternativ können andere Beschichtungsverfahren zum Aufbringen von thermisch leitfähigen Isolierschichten angewandt werden, wie z.B. Eloxieren, Harteloxieren, Lackieren mit thermisch leitfähigen Lacken, oder Drucken von elektrisch nicht leitenden (z.B. keramischen, Glas-ähnlichen oder aus Kunststoff bestehenden) Schichten oder thermische Spritzen von z.B. einer keramischen Beschichtung.
Gemäß einer bevorzugten Ausführungsform weist das Trägerelement auf einer der Trägerfläche abgewandten Seite ein oberflächenvergrößerndes Profil, wie z.B. Kühlrippen, auf. Dadurch kann das Trägerelement selbst für die notwendige Kühlung der LEDs sorgen. Bei einer alternativen Ausführungsform ist das Trägerelement mit einem entsprechend geformten Kühlkörper vorzugsweise flächig verbunden, so dass das Trägerelement nur zum Ableiten der Wärme an den Kühlkörper dient. Die Verbindung zwischen Trägerelement und Kühlkörper ist thermisch leitfähig. Beispielsweise kann zur Erhöhung der thermischen Leitfähigkeit eine Wärmeleitpaste angewandt werden.
Eine besondere Schwierigkeit beim Herstellen des LED-Trägerelements mit gekrümmter Oberfläche ist das Aufbringen der Leiterbahnen über die Krümmung hinweg oder über die Abkantung hinweg. Erfindungsgemäß wird hierzu das Tampondruck-Verfahren angewandt, welches aus dem Stand der Technik zwar bekannt ist, in der Regel aber nur zur dekorativen oder informativen Bedruckung von Formteilen, insbesondere Kunststoff-Spritzgussteilen angewandt wird. Beim Druck mittels eines Tampons passt sich dieser an die Form der Oberflächentopografie des zu bedruckenden Elements an. Dadurch eignet sich das Verfahren besonders zum Bedrucken von gewölbten Flächen. Der Tampon nimmt aufgrund seiner Elastizität die Form des zu bedruckenden Körpers an und kann somit verzerrungsfrei das zu bedruckende Muster übertragen. Als alternative Verfahren kommen der Siebdruck oder der Schablonendruck ebenfalls in Betracht. Diese eigenen sich für Trägerflächen mit schwacher Krümmung. Die Druckverfahren zum Aufbringen der Leiterbahnen können auch mehrere Schritte hintereinander umfassen, wobei in jedem Schritt nur ein Teil des Musters der Leiterbahnen aufgedruckt wird.

Erfindungsgemäß werden die Leiterbahnen durch Galvanisieren aufgebracht. Dazu wird vorzugsweise mittels eines der vorhergehend genannten Verfahren eine metallische Keimschicht aufgebracht, die anschließend beim Galvanisieren bis zur erforderlichen Dicke der Leiterbahn vergrößert wird. Dieses Verfahren ermöglicht es, die Leiterbahnen mit etwa konstanter Dicke über die Krümmung oder die Abkantungen der Trägerfläche hinweg auf das Trägerelement bzw. auf die darunter liegende Isolationsschicht aufzubringen. Ferner können auch subtraktive Verfahren, z.B. durch Ätzen oder mit einem Laser, Anwendung finden. Auch diese Verfahren eignen sich, um zunächst eine dünne Keimschicht für eine anschließende Galvanisierung (chemisch oder elektrolytisch) aufzubringen.

Die Leiterbahnen werden mit LEDs (worunter auch OLEDs zu verstehen sind) oder mit Sockelelementen für LEDs bestückt. Zum Bestücken ist gemäß einer Ausführungsform der Erfindung Löten oder Kleben mit einem leitfähigen Bond vorgesehen. Gemäß einer bevorzugten Ausführungsform werden die LEDs oder die LED-Sockel mittels eines Dampfphasen-Lötverfahrens an den Leiterbahnen angebracht. Das Dampfphasen-Lötverfahren (auch als Kondensationslöten bekannt) ermöglicht aufgrund des guten Wärmeübergangs zwischen der Oberfläche des Lötguts und dem kondensierenden Dampf ein schnelles Aufheizen der oberflächennahen Bereiche des Trägerelements auf die erforderliche Löttemperatur, wobei aufgrund des schnellen Aufheizprozesses nur eine geringere Wärmemenge in das Innere des Trägerelements geleitet wird. Durch die definierte Kondensationstemperatur des Dampfes kann eine Überhitzung der Bauteile vermieden werden. Bei dem sonst üblichen Reflow-Lötprozess werden die zu lötenden Baugruppen an der Oberfläche mittels Konvektion oder Infrarotstrahlung aufgeheizt, bis die erforderliche Löttemperatur erreicht ist. Bei diesen Lötprozessen wird aufgrund des langsameren Wärmeübergangs ein größerer Anteil der an der Oberfläche eingetragene Wärme in das Innere des Trägerelements geleitet, weshalb eine hohe Wärmemenge zur Erreichung der Löttemperatur notwendig ist. Die Wärmemenge wird in dem Trägerelement gespeichert, woraus sich längere Aufheiz- und Abkühlzeiten ergeben. Dies führt leicht zur Überhitzung der LEDs und damit zu deren Degradation oder thermischen Zerstörung. Durch das Dampfphasen-Lötverfahren werden diese Nachteile überwunden, weil aufgrund des schnelleren Aufheizprozesses eine geringere Wärmemenge in das Innere des Trägerelements geleitet wird. Ferner wird bei dem Lötverfahren ein Verrutschen oder Abfallen der LEDs oder LED-Sockel auf der nicht-ebenen, d.h. gekrümmten oder abgekanteten Trägerfläche des Trägerelements verhindert, indem die anzulötende Bauelemente mit Klebpunkten vor dem Lötverfahren fixiert werden.

Gemäß einer bevorzugten Ausführungsform übernimmt das LED-Trägerelement gleichzeitig die Funktion eines Gehäuses oder Teilgehäuses der Leuchte. Das LED-Trägerelement weist dazu Befestigungseinrichtungen auf, welche die Befestigung einer wenigstens teilweise transparenten Gehäusehälfte gegenüber der Trägerfläche ermöglichen. Vorzugsweise wird die wenigstens teilweise transparente Gehäusehälfte durch eine umlaufende Dichtung mit dem LED-Trägerelement verschlossen, um die elektronischen Bauelemente vor dem Eindringen von Feuchtigkeit oder Staub zu schützen.

Gemäß einer bevorzugten Ausführungsform sind ferner Befestigungselemente an dem LED-Trägerelement zur Montage des LED-Trägerelements an einem Leuchtenhalter, wie insbesondere an einem Mast oder einer Schiene, vorgesehen. Da das LED-Trägerelement aus einem mechanisch stabilen Material, wie insbesondere Aluminium oder einem anderen Metall gebildet ist, lassen sich diese Aufgabe eines herkömmlichen Leuchtengehäuses mit dem LED-Trägerelement leicht verbinden.

Weitere technische Einzelheiten und Vorteile der vorliegenden Erfindung werden durch die Beschreibung der bevorzugten Ausführungsformen anhand der beigefügten Figuren deutlich. In den Figuren ist Folgendes dargestellt:
- Figur 1: zeigt einen Schnitt durch ein LED-Trägerelement nach einer ersten Ausführungsform.
- Figur 2: zeigt einen Schnitt durch ein LED-Trägerelement gemäß einem anderen Beispiel.

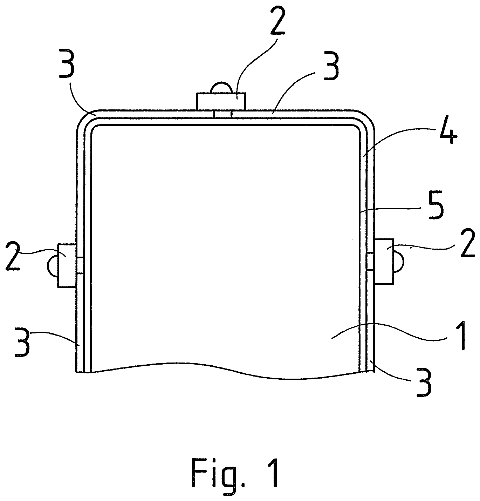

Bezug nehmend auf Figur 1 ist ein LED-Trägerelement nach der vorliegenden Erfindung dargestellt. Es umfasst einen massiven Körper 1, der in dem vorliegenden Beispiel aus Aluminium hergestellt ist. In dem gezeigten Teilausschnitt umfasst der Körper 1 einen etwa rechteckigen Abschnitt, an dem auf drei Seiten des Körpers zueinander abgewinkelte jeweils ebene Oberflächen gebildet werden, die als Trägerfläche 5 für LEDs 2 dienen.

Die Trägerfläche 5 weist in mehrere Raumrichtungen, so dass die darauf angebrachten LEDs 2 in verschiedene Raumwinkelbereiche zeigen. Durch die Gestaltung der Trägerfläche lässt sich demnach die Ausrichtung der Hauptabstrahlrichtung der LEDs 2 einstellen, so dass die Gesamtlichtverteilung der Leuchte entsprechend den Vorgaben für den Beleuchtungszweck der Leuchte realisiert werden kann.
Auf der Trägerfläche ist eine durchgehende Isolierschicht 4 aufgetragen. Die Isolierschicht 4 ist in dem vorliegenden Beispiel aus einer Keramik gebildet. Die Isolierschicht 4 ist durch eine plasmachemische Beschichtung auf der Aluminiumoberfläche des Körpers 1 gebildet. Die Schichtdicke weist etwa 100 µm auf. Die Isolierschicht 4 sorgt nicht nur für die elektrische Isolierung zu den anschließenden Leiterbahnen 3, sondern schützt außerdem den Aluminiumkörper 1 vor Verschleiß und Korrosion. Deshalb ist es auch bevorzugt, die Isolierschicht flächig über den gesamten Körper 1 aufzubringen. Außerdem weist die Isolierschicht auf der vom Körper 1 abgewandten Seite an der Oberfläche eine Porosität auf, welche die Haftung einer nachfolgenden Metallschicht begünstigt. Gleichzeitig ist die Isolierschicht auf der zum Körper 1 weisenden Seite so dicht, dass elektrische Überschläge zum Körper 1 verhindert werden.
Auf der Isolierschicht 4 ist eine Leiterbahn 3 aufgebracht, welche sich in dem gezeigten Querschnitt der Figur 1 über den gesamten Umfang des dargestellten Teils des Körpers 1 erstreckt. In der Richtung senkrecht zur dargestellten Schnittebene erstreckt sich die Leiterbahn 3, im Unterschied zu der Isolierschicht 4, jedoch nicht über den gesamten Körper 1. Die Leiterbahn 3 ist durch einen Galvanisierungsprozess aufgetragen. Dazu wurde zunächst eine metallische Keimschicht (z.B. Palladium) auf den Körper 1 bzw. die Isolierschicht 4 aufgetragen. Die Keimschicht wird in einem späteren Galvanik-Verfahren genutzt, um Kupfer bis zu einer gewünschten Schichtdicke für die Leiterbahnen 3 anzulagern. Die Leiterbahnen 5 haben eine Schichtdicke von etwa 5 µm bis 200 µm. Die Leiterbahn 3 oder die Keimschicht, welche später nach der Galvanisierung die Leiterbahn 3 bildet, ist mittels des Tampondruck-Verfahrens, welches für gekrümmte Flächen geeignet ist, aufgebracht.
Die LEDs 2 sind, wie in der Figur 1 dargestellt, direkt auf der elektrischen Leiterbahn 3 angebracht. Gemäß einer alternativen Ausführungsform kann auch eine Gruppe von LEDs jeweils auf einem gemeinsamen Sockel oder ein einzelne LED mit einem Sockel auf der Leiterbahn angebracht werden. Das direkte Anbringen von LEDs ist bevorzugt bei einer hohen Besetzungsdichte der Trägerfläche mit LEDs. Die Verwendung von Sockeln ist von Vorteil, wenn LEDs einzeln oder in einer Gruppe ausgetauscht werden sollen.

Als Verfahren zum Anbringen der LEDs oder der LED-Sockel auf die Leiterbahn wird insbesondere ein Dampfphasen-Lötprozess angewandt. Dabei wird das Lötgut in die Dampfphase einer nicht leitenden Flüssigkeit eingebracht. Der Aufheizungsprozess bei diesem Lötverfahren ist verhältnismäßig kurz, weil der Dampf aus der Dampfphase sehr schnell an der Oberfläche des Lötgutes kondensiert. Im Vergleich zu herkömmlichen Lötverfahren wird dadurch eine geringere Wärmemenge in das Lötgut übertragen und abgeleitet. Für Anlöten von LEDs ist das Verfahren deshalb bevorzugt, weil bei herkömmlichen Lötverfahren eine erhebliche Gefahr besteht, dass die LEDs überhitzt werden und somit geschädigt werden. Ferner wird bei dem Lötprozess ein Verrutschen der LEDs auf der gekrümmten Oberfläche vermieden, indem die LEDs mit Klebepunkten auf der Trägerfläche bzw. den Leiterbahnen gehalten werden. Auf die gleiche Weise können auch andere elektrische oder elektronische Bauelemente, wie z.B. Chips zum Steuern der LEDs, an den Leiterbahnen 3 angebracht werden.

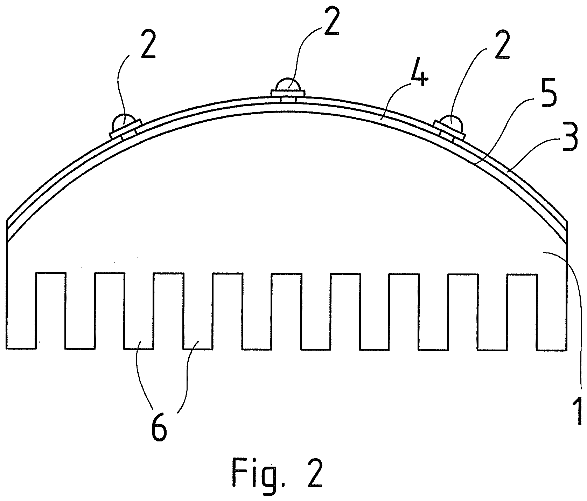

Figur 2 zeigt ein anderes Beispiel des LED-Trägerelements, wobei die gleichen Bezugszeichen wie in Figur 1 einander entsprechende Elemente bezeichnen. Bei diesem Beispiel ist die Trägerfläche 5 kontinuierlich gekrümmt. Die Krümmung ist konvex ausgebildet, um eine breitstrahlende Leuchte zu bilden. In anderen Beispielen kann auch eine konkave Krümmung vorgesehen sein. Die Krümmung kann sich entlang einer oder zwei Richtung der Trägerfläche erstrecken. Auch die Kombination von konkaver und konvexer Krümmung ist berücksichtigt.

Auf der der Trägerfläche abgewandten Seite des Trägerelements sind nach Figur 2 Kühlrippen 6 vorgesehen. Durch die Kühlrippen wird die über das Trägerelement abgeleitete Wärme der LEDs an die Umgebungsluft abgegeben.

Zahlreiche Abwandlungen der beschriebenen Ausführungsform sind im Rahmen der Erfindung, die in den Ansprüchen definiert wird, möglich.

### Bezugszeichenliste:

- 1: Massiver Körper
- 2: LEDs
- 3: Leiterbahnen
- 4: Isolierschicht
- 5: Trägerfläche
- 6: Kühlrippe

## Patentansprüche

1. LED-Trägerelement mit einem Körper (1), der eine Oberfläche besitzt, die als Trägerfläche (5) für LEDs (2) dient, wobei die Trägerfläche (5) Abkantungen aufweist, wobei auf der Trägerfläche Leiterbahnen (3) aufgebracht sind, die zur elektrischen Versorgung von LEDs (2) dienen, und die sich über die Abkantungen der Trägerfläche (5) erstrecken, und wobei LEDs (2) oder Sockelelemente für LEDs mit den Leiterbahnen elektrisch und mechanisch verbunden sind, derart, dass die Hauptabstrahlrichtungen wenigstens einiger der LEDs (2) in verschiedene räumliche Richtungen zeigen, wobei der Körper (1) aus einem metallischen Material, insbesondere aus Aluminium, gebildet ist und zwischen der Trägerfläche (5) und den Leiterbahnen (5) eine Isolierschicht vorgesehen ist, insbesondere eine Oxidschicht und/oder eine keramische Schicht, **dadurch gekennzeichnet, dass** die Leiterbahnen mittels eines Tampondruck-Verfahrens aufgebracht sind, wobei eine metallische Keimschicht mittels des Tampondruck-Verfahrens aufgebracht ist und die Leiterbahnen nachfolgend durch das Galvanisieren aufgedickt sind.

2. LED-Trägerelement nach Anspruch 1, wobei der Körper (1) aus einem Material mit einer Wärmeleitfähigkeit von wenigstens 15 W/Km, bevorzugt von wenigstens 100 W/Km, gebildet ist.

3. LED-Trägerelement nach einem der vorhergehenden Ansprüche, wobei das Trägerelement auf einer der Trägerfläche abgewandten Seite ein oberflächenvergrößerndes Profil, insbesondere Kühlrippen, aufweist.

4. LED-Trägerelement nach einem der vorhergehenden Ansprüche, wobei die LEDs (2) oder die LED-Sockel mittels eines Dampfphasen-Lötverfahrens an den Leiterbahnen (3) angebracht sind.

5. LED-Trägerelement nach einem der vorhergehenden Ansprüche, wobei das LED-Trägerelement Befestigungseinrichtungen aufweist, um eine wenigstens teilweise transparente Gehäusehälfte gegenüber der Trägerfläche (5) aufzunehmen.

6. LED-Trägerelement nach einem der vorhergehenden Ansprüche, welches Befestigungseinrichtungen zur Montage des LED-Trägerelements an einem Leuchtenhalter, insbesondere an einem Mast oder einer Schiene, aufweist.

7. Leuchte umfassend ein LED-Trägerelement nach einem der vorhergehenden Ansprüche.

8. Verfahren zum Herstellen eines LED-Trägerelements nach Anspruch 1, wobei die Leiterbahnen (3) mittels eines Tampondruck-Verfahrens aufgebracht werden, wobei eine metallische Keimschicht mittels des Tampondruck-Verfahrens aufgebracht wird, und die Leiterbahnen nachfolgend durch das Galvanisieren aufgedickt werden.

9. Verfahren nach Anspruch 8, welches ein Einbringen des Trägerelements in eine Dampfphase einer Flüssigkeit umfasst, um die LEDs (2) oder die LED-Sockel mit den Leiterbahnen mechanisch und elektrisch zu verbinden.

## Claims

1. LED carrier element with a body (1), which has a surface which serves as a carrying surface (5) for LED's (2), wherein the carrying surface (5) comprised folded edges, wherein conductor paths (3) are located on the carrying surface, which serve to provide the electrical supply to LED's (2) and extend over the folded edges of the carrying surface (5), and wherein LED's (2) or base elements for LED's are connected electrically and mechanically with the conductor paths, in such a way that the main radiation directions of at least some of the LED's (2) point in different spatial directions, wherein the body (1) is formed from a metallic material, in particular from aluminium, and provided between the carrying surface (5) and the conductor paths (5) is an insulation layer, in particular an oxide layer and/or a ceramic layer, **characterized in that** the conductor paths are applied by means of a pad printing process, wherein a metallic germinal layer is applied by means of the pad printing process, and the conductor paths are consequently thickened by the galvanizing.

2. LED carrier element according to claim 1, wherein the body (1) is formed from a material with a thermal conductivity of at least 15 W/Km, preferably of at least 100 W/Km.

3. LED carrier element according to any one of the preceding claims, wherein the carrier element exhibits a surface area increasing profile, in particular cooling ribs, on a side facing away from the carrying surface.

4. LED carrier element according to any one of the preceding claims, wherein the LED's (2) or the LED bases are applied on the conductor paths (3) by means of a vapour phase soldering process.

5. LED carrier element according to any one of the preceding claims, wherein the LED carrier element comprises securing devices, in order to accommodate at least partially transparent housing halves opposite the carrying surface (5).

6. LED carrier element according to any one of the preceding claims, which comprises securing devices for mounting the LED carrier element on a luminaire carrier, in particular a mast or a rail.

7. Light comprising an LED carrier element according to any one of the preceding claims.

8. Method for producing an LED carrier element according to claim 1, wherein the conductor paths (3) are applied by means of a pad printing process, wherein a metallic germinal layer is applied by means of the pad printing process, and the conductor paths are consequently thickened by the galvanizing.

9. Method according to claim 8, which comprises the introduction of the carrier element into a vapour phase of a fluid, in order to connect the LED's (2) or the LED bases to the conductor paths mechanically and electrically.

## Revendications

1. Elément de support de DEL, avec un corps (1) qui possède une surface qui sert de surface de support (5) pour des DEL (2), la surface de support (5) comportant des bords repliés, des pistes conductrices (3) étant appliquées sur la surface de support, qui servent à l'alimentation électrique de DEL (2) et s'étendent sur les bords repliés de la surface de support (5), et des DEL (2) ou des éléments de culot pour DEL étant raccordé(e)s électriquement et mécaniquement aux pistes conductrices de telle sorte que les directions de rayonnement principales d'au moins quelques-unes des DEL (2) sont dirigées dans différentes directions spatiales, le corps (1) étant formé d'un matériau métallique, en particulier d'aluminium, et une couche isolante étant prévue entre la surface de support (5) et les pistes conductrices (5), en particulier une couche d'oxyde et/ou une couche céramique, **caractérisé en ce que** les pistes conductrices sont appliquées au moyen d'un procédé de tampographie, une couche de germe métallique étant appliquée au moyen du procédé de tampographie, et les pistes conductrices étant ensuite épaissies par galvanisation.

2. Elément de support de DEL selon la revendication 1, le corps (1) étant formé d'un matériau doté d'une conductivité thermique d'au moins 15 W/Km, de préférence d'au moins 100 W/Km.

3. Elément de support de DEL selon l'une des revendications précédentes, l'élément de support comportant, sur un côté éloigné de la surface de support, un profil augmentant la surface, en particulier des ailettes de refroidissement.

4. Elément de support de DEL selon l'une des revendications précédentes, les DEL (2) ou les culots de DEL étant mis(es) en place sur les pistes conductrices (3) au moyen d'un procédé de brasage par phase vapeur.

5. Elément de support de DEL selon l'une des revendications précédentes, l'élément de support de DEL comportant des systèmes de fixation destinés à recevoir un demi-boîtier au moins partiellement transparent en face de la surface de support (5).

6. Elément de support de DEL selon l'une des revendications précédentes, lequel comporte des systèmes de fixation destinés au montage de l'élément de support de DEL sur une douille de lampe, en particulier sur un mât ou un rail.

7. Lampe comportant un élément de support de DEL selon l'une des revendications précédentes.

8. Procédé de fabrication d'un élément de support de DEL selon la revendication 1, les pistes conductrices (3) étant appliquées au moyen d'un procédé de tampographie, une couche de germe métallique étant appliquée au moyen du procédé de tampographie, et les pistes conductrices étant ensuite épaissies par la galvanisation.

9. Procédé selon la revendication 8, lequel comprend une mise en place de l'élément de support dans une phase vapeur d'un liquide pour raccorder mécaniquement et électriquement les DEL (2) ou les culots de DEL aux pistes conductrices.
